Europäisches Patentamt

European Patent Office

Office européen des brevets

(19)

(11) Veröffentlichungsnummer : **0 188 695**
**B1**

(12) # EUROPÄISCHE PATENTSCHRIFT

(45) Veröffentlichungstag der Patentschrift :
07.09.88

(51) Int. Cl.⁴ : **H 01 H 85/04, H 01 H 61/02**

(21) Anmeldenummer : 85114766.0

(22) Anmeldetag : 21.11.85

(54) **Platte als Schaltungsträger mit mindestens einer schichtförmigen Leiterbahn.**

(30) Priorität : 27.12.84 DE 3447531

(43) Veröffentlichungstag der Anmeldung :
30.07.86 Patentblatt 86/31

(45) Bekanntmachung des Hinweises auf die Patenterteilung : 07.09.88 Patentblatt 88/36

(84) Benannte Vertragsstaaten :
AT BE CH DE FR GB IT LI LU NL SE

(56) Entgegenhaltungen :
EP-A- 0 088 390
EP-A- 0 113 463
DE-A- 2 136 386
DE-A- 3 223 929
FR-A- 1 181 381
GB-A- 2 068 177
US-A- 3 538 444
US-A- 3 763 454
US-A- 4 423 401
US-A- 4 467 310

(73) Patentinhaber : Siemens Aktiengesellschaft Berlin
und München
Wittelsbacherplatz 2
D-8000 München 2 (DE)

(72) Erfinder : Dragotin, Alexander, Dipl.-Ing.
Edelweissstrasse 177
D-8039 Puchheim (DE)
Erfinder : Prussas, Herbert, Dipl.-Ing.
Mozartring 11
D-8069 Reichertshausen (DE)
Erfinder : Kaindl, Michael
Vogelleite 12
D-8068 Pfaffenhofen (DE)

## Beschreibung

Die Erfindung betrifft eine Weiterentwicklung der im Oberbegriff des Patentanspruches 1 definierten Platte, welche für sich zum Beispiel in der US-A-3 763 454 beschrieben ist.

Bei der Erfindung kann es sich prinzipiell um einen beliebigen Heizwiderstand handeln. Bevorzugt ist jedoch der Heizwiderstand für sich ebenfalls auf die Platte gedruckt, wobei sogar auch die darüber liegende Bedeckung durch eine Drucktechnik, z. B. durch Siebdruck, angebracht worden sein kann.

Die Erfindung wurde insbesondere zum Schutz der Schaltungen von Teilnehmeranschlüssen eines Fernsprech-Vermittlungssystems entwickelt. Die Erfindung hat jedoch weit darüber hinaus Bedeutung für den Schutz von Schaltungen, insbesondere gegen Zerstörung durch Kurzschluß mit Starkstromleitungen oder zum Schutz vor Überlastung schlechthin, solange die Überlastung mittelbar oder unmittelbar zu Übertemperaturen des Heizwiderstandes führt.

Die Aufgabe der Erfindung ist, den Schutz der Platte und/oder den Schutz von Bestandteilen ihrer Schaltung durch eine Schmelzsicherung mit besonders kräftiger Aufheizung des Heizwiderstandes zu erreichen, bevor (bei Bedarf sogar weit bevor) die Belastung des vom Sensor abgefühlten Bestandteils zur Zerstörung dieses Bestandteils oder anderer, vom Bestandteil repräsentierter Bauteile führt, wobei die Belastung des Bestandteils und damit die entsprechende Art des Sensors beliebig sein kann — es kann also sich z. B. um Wärmebelastung und einen wärmeempfindlichen Sensor handeln, oder z. B. um optische Belastung und optischen Sensor, oder mechanische Belastung und einem mechanischen Sensor usw..

Diese Sicherung ist so aufgebaut, daß sie weitgehend ebenfalls eine Schichtstruktur aufweisen kann, indem sie bei Bedarf weitgehend sogar durch eine Drucktechnik, z. B. durch Siebdruck, so hergestellt werden kann, daß sie einen besonders kleinen Raumbedarf und Flächenbedarf aufweist. Im Unterschied zu normalen Schmelzsicherungen unterbricht, z. B. schmilzt oder verdampft, jedoch die Soll-Unterbrechungsstelle nicht (oder nicht nur) wegen überstarker Ströme durch diese Soll-Unterbrechungsstelle, sondern vor allem (auch) wegen entsprechend starker Aufheizung der Soll-Unterbrechungsstelle mittels des Heizwiderstandes.

Diese Aufgabe wurde durch die im Patentanspruch 1 angegebenen Maßnahmen gelöst.

Die in den Unteransprüchen angegebenen zusätzlichen Maßnahmen gestatten zusätzliche Vorteile. So gestatten die Maßnahmen gem. Patentanspruch

2, durch nichtlineares Verhalten des Sensors und/oder des Verstärkers ein kräftiges rasches Aufheizen des Heizwiderstandes im Überlastungsfall und damit eine besonders hohe Sicherheit für die Platte und/oder ihre Schaltung erreichen zu können,

3, auch noch nachträglich auf der Platte die Sicherung anzubringen,

4, auch den Abschnitt in gleicher oder ähnlicher Weise wie die Leiterbahnen herstellen zu können,

5, die Menge des Materials, welches im Unterbrechungsfall an der Soll-Unterbrechungsstelle schmilzt oder sogar verdampft, verringern zu können, sowie den eigenen Stromfluß durch den Abschnitt bei Bedarf ebenfalls zum Durchschmelzen bzw. Verdampfen des Abschnitts mitausnutzen zu können,

6, ein sicheres, besonders rasches Schmelzen bzw. Verdampfen des Abschnittes vor dem Schmelzen bzw. Verdampfen der betreffenden Leiterbahnen erreichen zu können,

7, die Verschmutzung der Platte und/oder von Bestandteilen ihrer Schaltung und/oder von anderen Bauteilen der Umgebung, welche nicht auf der Platte angebracht sind (welche also z. B. auf anderen Platten angebracht sind) weitgehend verhindern zu können,

8, im Unterbrechungsfalle eine Überhitzung des Heizwiderstandes und damit z. B. sein Schmelzen bzw. Verdampfen mit allen Folgen für die Umgebung vermeiden zu können,

9, den Heizwiderstand nicht auf der Platte selbst anbringen zu müssen, sondern auf einer Folie, z. B. einer Glimmerfolie, zunächst getrennt von der Platte herstellen zu können und erst später den Heizwiderstand auf der Platte anbringen zu können,

10, die Wärmebelastung des Bauteils, bei Bedarf sogar über größere Entfernungen hinweg, rasch an den Sensor heranführen zu können, sowie, bei weitgehender oder völliger Bedeckung des Bauteils durch den Wärmeleitkörper, örtliche Überhitzungen an Bauteiloberflächen zumindest weitgehend verhindern zu können,

11, die Ansprechdauer der Sicherung im Unterbrechungsfall verringern zu können,

12, auf besonders einfache Weise die Ansprechdauer der Sicherung verringern zu können,

13, im Unterbrechungsfalle die Stromversorgung der Schaltung unterbrechen zu können,

14, die Verbindung zwischen dem Amt und dem Teilnehmer, genauer der Teilnehmeranschlußleitung, unterbrechen zu können,

15, örtliche Überhitzungen einzelner Stellen des Heizwiderstandes vermeiden zu können, sowie bei Bedarf durch entsprechende Erhöhung der Wärmekapazität eine dem Bedarf entsprechende Ansprechverzögerung der Sicherung erreichen zu können, sowie

16, einen räumlichen Abstand zwischen der Sicherung bzw. Soll-Unterbrechungsstelle einerseits und dem Heizwiderstand andererseits einhalten zu können, bei Bedarf sogar die gesamte vom Heizwiderstand abgegebene Wärme durch völlige Bedeckung des Heizwiderstandes mit dem Wärmeleitkörper abführen bzw. örtliche Überhitzungen einzelner Stellen des Heizwiderstandes vermeiden zu können.

Die Erfindung wird anhand der in den Figuren schematisch dargestellten Ausführungsbeispiele weiter erläutert. Dabei zeigt die Figur

1, eine Platte mit der amtsseitigen Schaltung für einen Teilnehmeranschluß eines Fernsprech-Vermittlungssystems, wobei eine erfindungsgemäß aufgebaute Sicherung auf die beiden Leitungen der Gleichstromversorgung der Teilnehmerleitungen, gesteuert von einem Sensor und Verstärker, einwirkt,

2, ein erfindungsgemäßes Beispiel mit diskreter kompakter Sicherung auf dem Heizwiderstand,

3, eine völlig schichtförmig herstellbare, sogar völlig durch Siebdruck herstellbare Weiterbildung der Erfindung,

4, eine speziell gestaltete Verengung als Abschnitt der Soll-Unterbrechungsstele in Draufsicht,

5, eine über einem Loch als Wärmestauanordnung angebrachte Variante der Sicherung in Draufsicht,

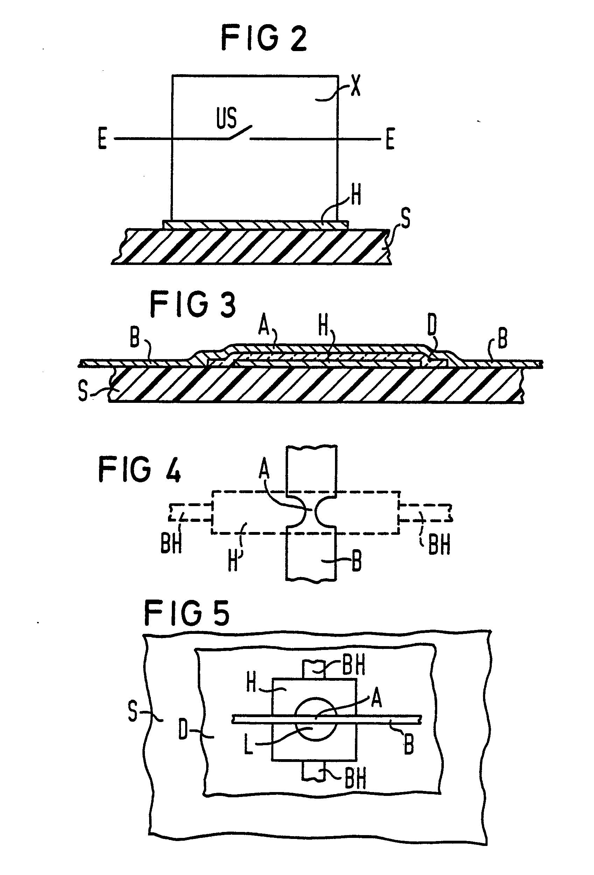

6, eine ähnlich wie Fig. 5 aufgebaute Variante der Sicherung in Seitensicht,

7, eine zwei Soll-Unterbrechungsstelle und einen einzigen Heizwiderstand aufweisende Variante, also sozusagen zwei Sicherungen mit gemeinsamen Heizwiderstand, und zwar mit einer für beide Sicherungen gemeinsamen Abdeckkappe,

8, einen wenig Oberfläche außerhalb der Soll-Unterbrechungsstelle aufweisenden Heizwiderstand,

9, eine Variante der Sicherung mit Loch als Wärmestauanordnung und mit einer Folie, z. B. Glimmerplatte, als Träger sowohl für den Heizwiderstand als auch für — hier zwei getrennte — Soll-Unterbrechungsstellen,

10, das Schaltungsprinzip für eine Soll-Unterbrechungsstelle, welche, in die Leiterbahn des Heizwiderstandes in Reihe geschaltet, eingefügt ist und daher den Strom im Heizwiderstand im Unterbrechungsfall unterbricht,

11, eine eine kompakte diskrete Sicherung aufweisende Variante mit zwei Wärmeleitkörpern beim Heizwiderstand, nämlich mit einem eine hohe Wärmekapazität aufweisenden Wärmeleitkörper auf jeder Seite des Heizkörpers, sowie

12, eine einen Sensor aufweisenden Betriebswiderstand als Bauteil, wobei ein Wärmeleitkörper mit relativ hoher Wärmekapazität so beim Betriebswiderstand angebracht ist, daß dieser kaum irgendwo eine lokale Überhitzung aufweisen kann und daß eine gewisse Ansprechverzögerung erreicht ist.

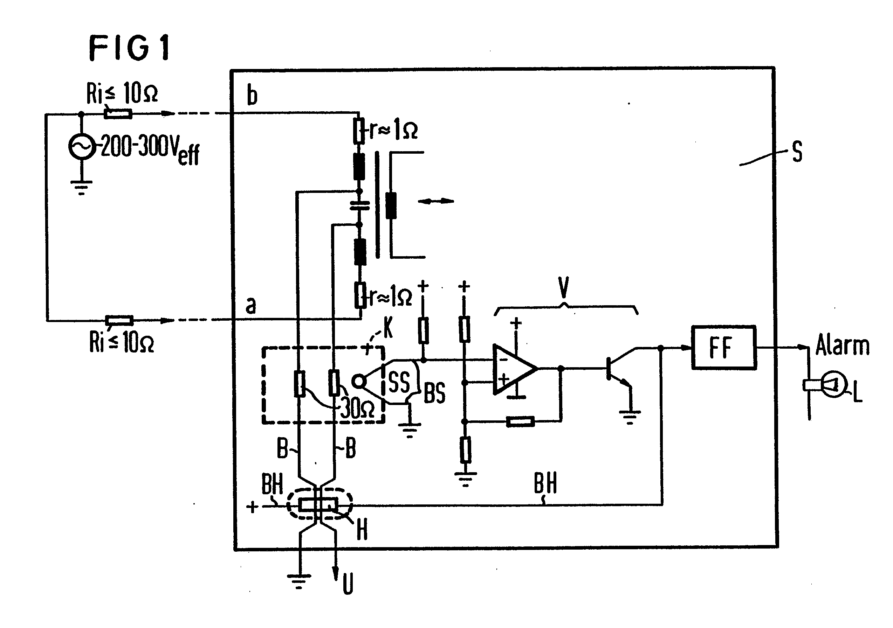

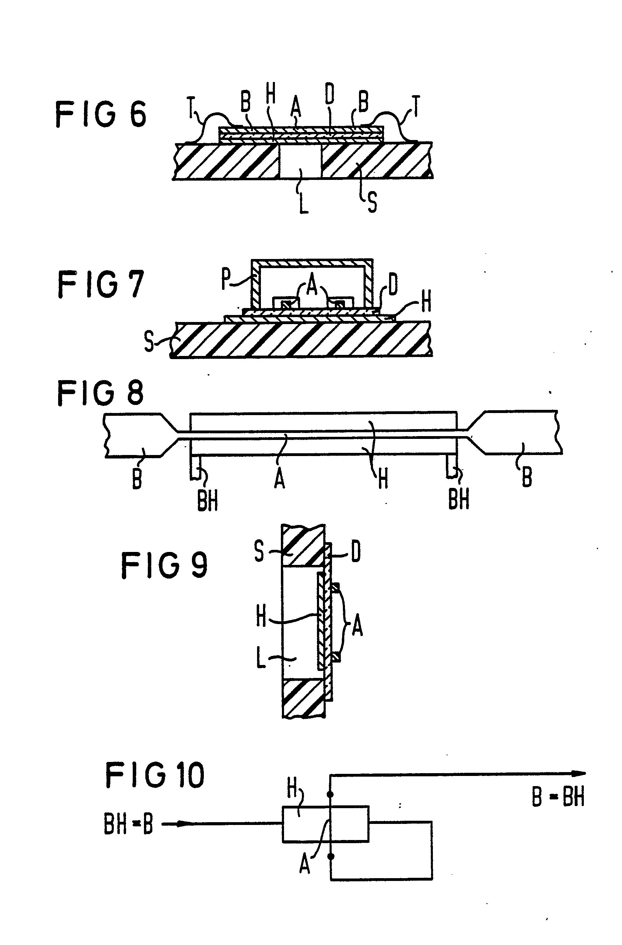

Die Figur 1 zeigt ein Anwendungsbeispiel einer speziellen Variante der Erfindung, bei dem auf dem Substrat S die amtsseitige Schaltung einer Teilnehmeranschlußleitung eines Fernsprech-Vermittlungssystems angebracht ist. Das Substrat S trägt eine Vielzahl schichtförmiger Leiterbahnen B, welche z. B. Dünnfilmleiterbahnen und/oder Dickschichtleiterbahnen und/oder geätzte Leiterbahnen darstellen können. Auf dem Substrat S links unten ist ein Dickschicht-Heizwiderstand H mit eigenen schichtförmigen Leiterbahnen BH zu seiner Aufheizung angebracht. Über diesem Heizwiderstand H wurde zunächst eine elektrisch isolierende, thermisch jedoch gut leitende schichtförmige Bedeckung D angebracht, vgl. Fig. 3 und 7, wobei über der Bedeckung D ihrerseits eine auf Übertemperaturen ansprechende elektrische Sicherung, nämlich eine Soll-Unterbrechungsstelle A zum Unterbrechen von Leiterbahnen B in thermisch gut kontaktierter Weise angebracht ist. Die Soll-Unterbrechungsstelle A ist also jeweils in Längsrichtung in die betreffende, im Unterbrechungsfalle zu unterbrechende Leiterbahn B eingefügt, wobei es sich bei diesen Leiterbahnen B um die Gleichstrom-Speiseleitungen zur Stromversorgung der a- und der b-Teilnehmeradern handelt.

Im Unterschied zu herkömmlichen Schmelzsicherungen, bei denen die Soll-Unterbrechungsstelle aufgrund eigener Überlastung durch Strom schmilzt bzw. verdampft, wird bei der erfindungsgemäßen Sicherung das Schmelzen bzw. Verdampfen der betreffenden Soll-Unterbrechungsstelle A jeweils unter, zumindest erheblicher, Mitwirkung des Heizwiderstandes H bewirkt. Erfindungsgemäß wird nämlich die Soll-Unterbrechungsstelle A dadurch zum Schmelzen bzw. Verdampfen gebracht, daß der Heizwiderstand H so stark aufgeheizt wird, daß die thermisch mit dem Heizwiderstand H gut kontaktierte Soll-Unterbrechungsstelle A schließlich schmilzt oder sogar verdampft, — auch wenn der eigene Strom, welcher durch die betreffenden Soll-Unterbrechungsstelle A fließt, viel zu klein ist, um alleine für sich das Schmelzen bzw. Verdampfen dieser Soll-Unterbrechungsstelle A bewirken zu können.

Wenn bei der Erfindung ein in vielen Fällen bevorzugter schichtförmiger Aufbau der Soll-Unterbrechungsstelle angebracht ist, welche im Unterbrechungsfalle schmilzt oder verdampft, so ist trotzdem die Erfindung nicht auf die Anwendung von schmelzenden oder verdampfenden Soll-Unterbrechungsstellen A beschränkt.

Die Erfindung ist nicht auf die Mitausnutzung der ohnehin vorhandenen Widerstände der Schaltung als Heizwiderstend H der erfindungsgemäß aufgebauten Sicherung beschränkt. Bei der Erfindung kann nämlich der betreffende Heizwiderstand H auch ein eigener Widerstand sein, welcher für sich von einem, z. B. eine hohe Verstärkung und sogar eine Ausgangsleistung aufweisenden, Verstärker V aufgeheizt sein kann, vgl. Fig. 1. Der Eingang dieses Verstärkers V wird bevorzugt von einem Sensor SS gesteuert, welcher ein Bauteil der Schaltung abtastet und damit feststellt, ob das betreffende Bauteil überlastet wird. Dieses Bauteil kann jedoch auch als nur repräsentativ abgetastetes Bauteil verwendet werden, indem dieses abgetastete Bauteil repräsentativ für die Überlastung anderer Bauteile der Schaltung der Platte abgetastet wird. Die Art der Belastung ist dabei grundsätzlich beliebig, wobei jedoch der betreffende Sensor an die zu messende Art der Belastung angepaßt sein muß. z. B. kann die Wärmebelastung mittels eines wärmeempfindlichen Sensors gemessen werden. Es kann jedoch auch z. B. die optische Belastung eines eine Fotodiode bildenden Bauteils durch einen lichtempfindlichen Sensor gemessen werden. Auch kann die Schallbelastung oder Stoßbelastung durch einen entsprechenden druckempfindlichen Sensor SS gemessen werden, usw..

Durch einen solchen Sensor SS und Verstärker V kann eine besonders kräftige Aufheizung des Heizwiderstandes H der erfindungsgemäß aufgebauten Sicherung erreicht werden, bevor — bei Bedarf sogar lange bevor — die betreffende, vom Sensor abgetastete Belastung des abgetasteten Bestandteils eine Zerstörung dieses Bestandteils, oder Zerstörung davon repräsentierter anderer Bestandteile, anzeigt.

Je größer die Ausgangsleistung des betreffenden Verstärkers V ist, um so rascher kann die Soll-Unterbrechungsstelle im Unterbrechungsfalle schmelzen oder verdampfen. Besonders rasch und zuverlässig wird die erfindungsgemäß gesteuerte Soll-Unterbrechungsstelle A unterbrochen, wenn der Sensor SS und/oder sein Verstärker V eine deutliche Ansprechschwelle bzw. Nichtlinearität aufweist, wodurch der Heizwiderstand H normalerweise überhaupt nicht vom Verstärker V geheizt wird, wobei jedoch bei Überschreiten der Ansprechschwelle der Verstärker V sehr rasch so stark den Heizwiderstand H aufheizt, daß die Soll-Unterbrechungsstelle zuverlässig sofort unterbrochen wird. Selbst wenn der vom Sensor SS gemessene Parameter nur langsam ansteigt, wird dann der Heizwiderstand oberhalb des entsprechenden Schwellwertes des Parameters sehr rasch auf eine Temperatur aufheizbar, welche ausreicht, um die Soll-Unterbrechungsstelle A zuverlässig sofort zu unterbrechen — auch wenn also z. B. zufällig kein eigener Strom durch die betreffende Soll-Unterbrechungsstelle bzw. durch die betreffende in Reihe liegende Leiterbahn B im Unterbrechungsfalle fließen würde.

Die Soll-Unterbrechungsstelle kann auf mehrere Weisen, gesteuert durch den Heizwiderstand H, unterbrochen werden, z. B. unter Mitwirkung eines Bimetallstreifens. Figur 2 zeigt ein solches Beispiel, bei dem nämlich eine Sicherung A als Ganzes durch ein diskretes kompaktes Bauteil X mit kompakter Soll-Unterbrechungsstelle, also z. B. mit einer Bimetall-Unterbrechungsstelle US, gezeigt ist. Eine solche Sicherung X kann auch kompakte Drähte E als Anschlüsse für die Soll-Unterbrechungsstelle US aufweisen, statt schichtförmige Leiterbahnen auch in ihrem Inneren aufzuweisen.

Eine solche kompakte Sicherung X kann auch eine reversibel steuerbare Soll-Unterbrechungsstelle US aufweisen. Z. B. kann die Soll-Unterbrechungsstelle US selbsttätig die Unterbrechung wieder beenden, wenn die Temperatur des Heizwiderstandes H wieder zurückgeht — in diesem Fall kann die Soll-Unterbrechungsstelle US z. B. durch den genannten Bimetallstreifen gebildet werden. Die kompakte Sicherung X kann jedoch auch eine durch Druckknopf reversierbare, durch eine Feder vorgespannte Soll-Unterbrechungsstelle in für sich bekannter Weise enthalten.

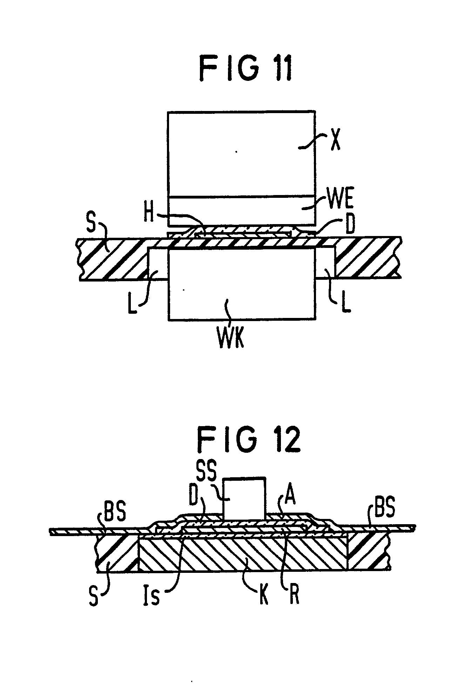

Figur 11 zeigt ein anderes Beispiel mit einer solchen kompakten Sicherung X, bei welcher beim Heizwiderstand H, nämlich darüber und darunter, vollflächig den Heizwiderstand H bedeckende Wärmeleitkörper WE, WK angebracht sind. Diese Wärmeleitkörper WE, WK weisen bei diesem Beispiel eine besonders hohe eigene Wärmekapazität auf, so daß die vom Heizwiderstand H über die Wärmeleitkörper WE, WK gesteuerte Sicherung X erst mit einer gewissen zeitlichen Verzögerung anspricht, welche der Wärmekapazität der beiden Wärmeleitkörper WE, WK entspricht. Durch entsprechende Dimensionierung der Wärmekapazität — man kann sie auch bewußt möglichst klein machen — kann man also die Ansprechzeit der erfindungsgemäß gesteuerten Sicherung beeinflussen.

Wenn die Soll-Unterbrechungsstelle A einen leitenden schichtförmigen Abschnitt A im Zuge einer Leiterbahn B bildet, vgl. Fig. 1, 3 bis 10 und 12, dann kann man vorteilhafterweise diesen Abschnitt A in gleicher oder ähnlicher Weise wie die betreffende Leiterbahn B herstellen. Außerdem ist dann der Raum- und Platzbedarf auf dem Substrat S besonders klein. Hier ist die Wärmekapazität zwischen dem Heizwiderstand H und dem Abschnitt A besonders klein, solange keine zusätzlichen, die Wärmekapazität erhöhenden Maßnahmen getroffen werden. Ein solcher schichtförmiger Aufbau des Abschnittes A gestattet also auch, eine besonders kurze Ansprechzeit der Sicherung zu erreichen.

Der Leitungsquerschnitt im Abschnitt A kann erheblich kleiner als der Leitungsquerschnitt der betreffenden Leiterbahn B gemacht werden, vgl. Fig. 4 und 8. Dadurch ist die Menge des Materials, welche im Unterbrechungsfall an der Soll-Unterbrechungsstelle schmilzt oder verdampft, erheblich verringert. Zusätzlich kann durch derartige Dimensionierungen des Abschnittes A auch erreicht werden, daß der eigene Stromfluß durch den betreffenden Abschnitt bei Bedarf ebenfalls erheblich zum Durchschmelzen bzw. Verdampfen dieses Abschnittes mit ausgenutzt werden kann.

Wenn der Abschnitt A, vgl. Fig. 1, 3 bis 10 und 12, insbesondere Fig. 4 und 8, jeweils aus einem Material besteht, welches bei niedrigerer Temperatur schmilzt bzw. verdampft als die übrigen Teile der betreffenden Leiterbahn B, dann wird mit besonders großer Sicherheit das Schmelzen bzw. Verdampfen dieses Abschnittes schon dann erreicht, wenn die sonstigen Strecken der betreffenden Leiterbahn noch nicht schmelzen bzw. verdampfen. Durch eine solche Wahl eines abweichenden Materials für den Abschnitt A, bezogen auf das Material der betreffenden Leiterbahn B, kann zusätzlich erreicht werden, daß der betreffende Abschnitt AS besonders rasch schmilzt bzw. verdampft.

Wenn also auf dem Substrat S gleichzeitig mehrere Abschnitte A von ein und demselben Heizwiderstand H gesteuert werden, vgl. Fig. 1, 7 und 9, wenn also mehrere solche Sicherungen einen gemeinsamen Heizwiderstand H zur gemeinsamen Steuerung aller Sicherungen aufweisen, dann können einige der Abschnitte A aus einem anderen Material hergestellt werden als die übrigen Abschnitte dieser von dem gemeinsamen Heizwiderstand H gesteuerten Sicherungen. Auf diese Weise ist erreichbar, daß mit Sicherheit ein Teil der Sicherungen bzw. ihrer Soll-Unterbrechungsstellen im Unterbrechungsfall früher schmilzt bzw. verdampft als der Rest der Soll-Unterbrechungsstellen, was in vielen Anwendungsfällen erwünscht ist.

Die schichtförmigen Abschnitte A können mit einer Abdeckkappe P abgedeckt werden, welche im Unterbrechungsfalle Spritzer bzw. Dämpfe der geschmolzenen bzw. verdampfenden Abschnitte A zumindest weitgehend abfangen, vgl. Fig. 7. Die Form der Abdeckkappe ist an sich beliebig wählbar. Zum Beispiel kann sie rechteckig sein, um mit besonders wenig Schwierigkeiten mittels eines Manipulators die Abdeckkappe P über den Abschnitten A anbringen, z. B. ankleben zu können.

Wenn ein gemeinsamer Heizwiderstand H gleichzeitig mehrere Abschnitte A steuert, dann kann einer dieser Abschnitte in Serie zum betreffenden Heizwiderstand H geschaltet sein, so daß dieser Abschnitt A im Unterbrechungsfalle den Strom im Heizwiderstand H unterbricht und eine Überhitzung bzw. Zerstörung dieses Heizwiderstandes H zu verhindern gestattet, vgl. Fig. 10. Darüber hinaus ist es in vielen Fällen günstig, die vom gemeinsamen Heizwiderstand H gesteuerten Abschnitte A so zu dimensionieren, daß im Unterbrechungsfall der den Heizwiderstand H abschaltende Abschnitt A als letzter schmilzt bzw. verdampft, nachdem alle übrigen, von diesem Heizwiderstand gesteuerten Abschnitte A also schon längst geschmolzen bzw. verdampft sind. Auf diese Weise kann man nämlich ein sicheres Unterbrechen der übrigen Abschnitte A sicherstellen und einen Schutz des gemeinsamen Heizwiderstandes durch abschließende Selbstabschaltung erreichen.

Der Heizwiderstand H kann grundsätzlich durch einen Betriebswiderstand gebildet sein, welcher ohnehin in der Schaltung der Platte zum Betrieb der betreffenden Schaltung nötig ist. Bei dem in Fig. 1 gezeigten Beispiel sind zwei solche Betriebswiderstände mit je 30 Ohm in den Speicherleitungen B zur Gleichstromversorgung der Teilnehmeradern gezeigt. An sich können also jeder dieser beiden Heizwiderstände, oder sogar beide Heizwiderstände gemeinsam, unmittelbar über eine Bedeckung erfindungsgemäß auf Soll-Unterbrechungsstellen wirken — z. B. auch, indem die betreffenden Soll-Unterbrechungsstellen in einer kompakten Sicherung X gemäß Fig. 2 und 11 angebracht sind (eine Bedeckung D auch dort anzubringen, erübrigt sich in diesem Falle häufig, da bereits häufig das Gehäuse der kompakten Sicherung X für sich die Bedeckung darstellt und alle Funktionen der Bedeckung mitübernimmt).

Es wurden bereits verschiedene Varianten für die Herstellung der Bedeckung D angegeben. Die Bedeckung D kann jedoch auch noch auf weitere Arten hergestellt sein. So kann die Bedeckung D durch eine Folie D gebildet werden, auf deren einen Seite der Heizwiderstand H aufgedruckt ist und auf deren anderen Seite die Soll-Unterbrechungsstelle A bzw. der Abschnitt A angebracht ist, vgl. Fig. 6 und 9. Die Folie D kann z. B. aus Glimmer sein. Auf diese Weise muß der Heizwiderstand nicht unmittelbar auf der Platte selbst angebracht werden, sondern kann auf dieser Folie zunächst getrennt hergestellt werden und erstspäter auf der Platte angebracht werden. Außerdem kann mittels einer solchen Folie D auch ein lufterfülltes Loch L im Substrat S bedeckt werden, vgl. die Beispiele in Fig. 5, 6 und 9. Das Loch L stellt dabei eine Wärmestauanordnung L dar, welche auf der der Soll-Unterbrechungsstelle A abgewandten Seite des Heizwiderstandes H angebracht ist. Eine solche Wärmestauanordnung L verhindert, daß die vom betreffenden Widerstand bzw. Heizwiderstand H erzeugte Wärme das Substrat S aufheizt, was die Ansprechzeit der erfindungsgemäß aufgebauten Sicherung vergrößern würde. Eine Wärmestauanordnung L unter dem Heizwiderstand H hat also einen sehr hohen Wärmewiderstand und/oder eine extrem kleine Wärmekapazität, wodurch die Ansprechzeit dieser erfindungsgemäß aufgebauten Sicherung entsprechend kurz wird.

Im Bedarfsfalle ist es jedoch auch möglich, die Ansprechzeit der Sicherung zu vergrößern. Eine solche Maßnahme wurde bereits im Zusammenhang mit Fig. 11 beschrieben. Es ist jedoch auch möglich, beim wärmeempfindlichen Sensor SS bzw. bei dem von ihm auf Wärmeentwicklung abgetasteten Bauteil 8, also z. B. bei einem ohnehin in der Schaltung angebrachten Betriebswiderstand R, zusätzlich einen Wärmeleitkörper K anzubringen, vgl. Fig. 12. Andererseits ist jedoch auch möglich, bei dem wärmeempfindlichen, in Fig. 12 gezeigten Sensor SS, vgl. auch Fig. 1, bzw. bei dem von ihm abgetasteten Bauteil R, einen möglichst wenig eigene Wärmekapazität aufweisenden Wärmeleitkörper K anzubringen, welcher die Wärme des betreffenden Bauteils R zum betreffenden Sensor SS rasch, bei Bedarf über größere Entfernungen hinweg, leitet, vgl. Fig. 1 und 12, und welcher z. B. auch elektrisch isoliert, vgl. Is, in einem Loch des Substrates S liegen kann. Bei weitgehender oder völliger Bedeckung des Bauteils R durch den Wärmeleitkörper K wird zusätzlich verhindert, daß örtliche Überhitzungen an einzelnen Stellen der bedeckten Bauteiloberflächen auftreten.

Auf dem Substrat S bzw. auf der Platte kann auch zusätzlich ein Flip-Flop FF oder eine sonstige Alarmeinrichtung, z. B. eine Lampe L angebracht sein, vgl. die Schaltung in Fig. 1, welche anzeigt, daß die betreffende Sicherung angesteuert wurde bzw. daß die betreffende Soll-Unterbrechungsstelle A unterbrochen wurde. Auf diese Weise ist es leicht möglich, eine außer Betrieb gesetzte Schaltung einer Platte unter einer Vielzahl solcher ähnlicher Platten selbst in großen Anlagen schnell ausfindig zu machen, obwohl der Platte selbst rein äußerlich sonst nichts oder wenig anzusehen sein mag -vgl. die anhand von Fig. 7 erläuterte Abdeckkappe P, welche die Spuren des Durchschmelzens bedeckt.

Die Erfindung ist, wie bereits erläutert, nicht auf eine spezielle Art von Überlastung begrenzt, gegen welche die Sicherung schützen soll. Die Erfindung ist also auch nicht auf den in Fig. 1 angedeuteten Fall begrenzt, daß ein niederohmiger Kurzschluß zwischen den beiden Teilnehmeradern eines Fernsprech-Vermittlungssystems einerseits mit einem öffentlichen Starkstromnetz (220 V) andererseits auftritt. Insbesondere sind auch andersartige Störungen — auch bei solchen Teilnehmeradern — abgesichert, z. B. also auch Störungen, welche Blitze induktiv und/oder kapazitiv auslösen.

Der Flächenaufwand für den Heizwiderstand H ist besonders gering, wenn er nahezu vollständig, vgl. Fig. 8, durch den Abschnitt A bedeckt wird.

**Patentansprüche**

1. Platte als Schaltungsträger mit
— mindestens einer schichtförmigen Leiterbahn (B), also z. B. Dünnfilmleiterbahn (B) und/oder Dickschichtleiterbahn (B) und/oder geätzten Leiterbahn (B), auf einem plattenförmigen Substrat (S),
— einem entsprechend einer Strombelastung aufgeheizten, z. B. schichtförmigen, Heizwiderstand (H), welcher z. B. als Dickschichtwiderstand (H) auf der Substratoberfläche (S) angebracht sein kann,
— einer elektrisch isolierenden, thermisch zumindest einigermaßen gut leitenden, z. B. schichtförmigen, Bedeckung (D) auf dem Heizwiderstand (H), und
— einer auf der Bedeckung (D) angebrachten, von dem Heizwiderstand (H) durch die Bedeckung (D) getrennten, auf Übertemperaturen ansprechenden, thermisch gut kontaktiert angebrachten, elektrischen Sicherung (A), welche eine Soll-Unterbrechungsstelle (A) zum Unterbrechen der Leiterbahn (B), in welche die Soll-Unterbrechungsstelle (A) in Längsrichtung eingefügt ist, enthält, insbesondere für Teilnehmeranschluß-Trägerplatten, dadurch gekennzeichnet, daß
— der Heizwiderstand (H) von einem Verstärker (V) gespeist wird, und
— der Verstärker (V) von einem, die elektrische, thermische, optische, akustische und/oder mechanische Belastung einer Leiterbahn (B) oder eines Bauteiles (R) der Platte messenden, Sensor (SS) gesteuert wird.

2. Platte nach Patentanspruch 1, dadurch gekennzeichnet, daß
— der Sensor (SS) und/oder der Verstärker (V) einen solchen Ansprechschwellwert aufweist, daß, auch bei nur langsamem Ansteigen des vom Sensor (SS) gemessenen Parameters, der Heizwiderstand (H) erst oberhalb des Schwellwertes vom Verstärker (V) rasch auf eine Temperatur aufgeheizt wird, die ausreicht, um rasch die Soll-Unterbrechungsstelle (A) zu unterbrechen.

3. Platte nach Patentanspruch 1 oder 2, dadurch gekennzeichnet, daß
— die Sicherung (A) als Ganzes ein diskretes kompaktes Bauteil (X) bildet.

4. Platte nach Patentanspruch 1, 2 oder 3, dadurch gekennzeichnet, daß
— die Soll-Unterbrechungsstelle (A) einen leitenden schichtförmigen Abschnitt (A) im Zuge einer Leiterbahn (B) bildet.

5. Platte nach Patentanspruch 4, dadurch gekennzeichnet, daß
— der Leitungsquerschnitt im Abschnitt (A) kleiner als in der betreffenden Leiterbahn (B) ist.

6. Platte nach Patentanspruch 4 oder 5, dadurch gekennzeichnet, daß
— der Abschnitt (A) aus einem Material besteht, welches bei niedrigerer Temperatur schmilzt als die übrigen Teile der betreffenden Leiterbahn (B).

7. Platte nach einem der Patentansprüche 4, 5 oder 6, dadurch gekennzeichnet, daß
— der Abschnitt (A) mit einer bei Unterbrechung Spritzer abfangenden Deckkappe (P) abgedeckt ist, und
— der Abschnitt (A) räumlich zwischen der Abdeckkappe (P) und der Bedeckung (D) angebracht ist.

8. Platte nach einem der Patentansprüche 1 bis 7, dadurch gekennzeichnet, daß
— der Heizwiderstand (H) gleichzeitig auf mehrere Soll-Unterbrechungsstellen (A) wirkt, von welchen eine besondere Soll-Unterbrechungsstelle (A) so dimensioniert ist, daß sie im Unterbrechungsfall als letzte ihre Leiterbahn (B = BH) völlig unterbricht, und
— die besondere Soll-Unterbrechungsstelle (A) in Reihe zum Heizwiderstand (H) geschaltet ist und daher im Unterbrechungsfall den Strom im Heizwiderstand (H) unterbricht.

9. Platte nach einem der Patentansprüche 1 bis 8, bevorzugt nach Patentanspruch 4, 5 oder 8, dadurch gekennzeichnet, daß
— die Bedeckung (D) durch eine Folie (D) gebildet wird, auf deren einen Seite der Heizwiderstand (H) aufgedruckt ist und auf deren anderen Seite die Soll-Unterbrechungsstelle (A) angebracht ist.

10. Platte nach einem der Patentansprüche 1 bis 9 dadurch gekennzeichnet, daß
— bei einem wärmeempfindlichen Sensor (SS), bzw. beim von ihm gemessenen Bauteil (R), ein Wärmeleitkörper (K) angebracht ist.

11. Platte nach einem der Patentansprüche 1 bis 9, dadurch gekennzeichnet, daß
— auf der der Soll-Unterbrechungsstelle (A) abgewandten Seite des Heizwiderstandes (H) eine schlecht wärmeleitende Wärmestauanordnung (L) angebracht ist.

12. Platte nach Patentanspruch 11, dadurch gekennzeichnet, daß
— die Wärmestauanordnung (L) durch ein Luft enthaltendes Loch (L) in dem Substrat unter dem Heizwiderstand (H) gebildet wird.

13. Platte nach einem der Patentansprüche 1 bis 12, dadurch gekennzeichnet, daß

— die Soll-Unterbrechungsstelle (A) in eine Leiterbahn (B) der Stromversorgung der Schaltung eingefügt ist.

14. Platte nach einem der Patentansprüche 1 bis 12, dadurch gekennzeichnet, daß

— die Schaltung eine Teilnehmeranschlußschaltung eines Fernsprechsystems bildet, und

— die Soll-Unterbrechungsstelle (A) in eine eine Teilnehmeranschlußader (a, b) bildende Leiterbahn eingefügt ist.

15. Platte nach einem der vorhergehenden Patentansprüche, dadurch gekennzeichnet, daß

— beim Heizwiderstand (H) eine Wärmekapazität (WE, WK) angebracht ist.

16. Platte nach Patentanspruch 15, dadurch gekennzeichnet, daß

— die Wärmekapazität durch einen entsprechend dimensionierten Wärmeleitkörper (WE, WK) gebildet wird.

## Claims

1. A board as a circuit carrier comprising :

— at least one film-like conductor path (B), thus e. g. a thin-film conductor path (B) and/or thick-film conductor path (B) and/or etched conductor path (8) on a disc-shaped substrate (S) ;

— a heating resistor (H) which is heated in accordance with a current load, and which for example is in the form of a film, which can be arranged as a thick-film resistor (H) on the substrate surface (S) for example ;

— an electrically insulating, e. g. film-like cover (D), which at least to some extent is a good thermal conductor, on the heating resistor (H) ; and

— an electric fuse (A) which is arranged on the cover (D), is separated from the heating resistor (H) by the cover (D), responds to excess temperatures, is provided with a good thermal contact, and which contains a theoretical interruption point (A) for the interruption of the conductor path (B) into which the theoretical interruption point (A) is introduced in the longitudinal direction,

in particular for subscriber terminal carrier boards ; characterised in that

— the heating resistor (H) is supplied by an amplifier (V) ; and

— the amplifier (V) is controlled by a sensor (SS) which measures the electrical, thermal, optical, acoustic and/or mechanical load of a conductor path (B) or a component (R) of the board.

2. A board as claimed in Claim 1, characterised in that the sensor (SS) and/or the amplifier (V) have a response threshold value which is such that, even in the event of there only being a slow increase in the parameter measured by the sensor (SS), only above a threshold value is the heating resistor (H) heated rapidly by the amplifier (V) to a temperature which is sufficient to rapidly interrupt the theoretical interruption point (A).

3. A board as claimed in Claim 1 or 2, characterised in that

— the fuse (A) as a whole forms a discrete, compact component (X).

4. A board as claimed in Claim 1, 2 or 3, characterised in that the theoretical interruption point (A) forms a conductive, film-like section (A) in the course of a conductor path (B).

5. A board as claimed in Claim 4, characterised in that the conductivity cross-section in the section (A) is smaller than in the respective conductor path (B).

6. A board as claimed in Claim 4 or 5, characterised in that

— the section (A) consists of a material which melts at a lower temperature than the remaining parts of the respective conductor path (B).

7. A board as claimed in one of Claim 4, 5 or 6, characterised in that

— the section (A) is covered by a covering cap (P) which collects splashes in the event of an interruption ; and

— the section (A) is located between the covering cap (P) and the cover (D).

8. A board as claimed in one of Claims 1 to 7, characterised in that

— the heating resistor (H) acts simultaneously upon a plurality of theoretical interruption points (A) of which one particular theoretical interruption point (A) is dimensioned to be such that, in the event of an interruption, it is the last to completely interrupt its conductor path (B = BH) ; and

— the special theoretical interruption point (A) is connected in series to the heating resistor (H) and therefore interrupts the current in the heating resistor (H) in the event of an interruption.

9. A board as claimed in one of Claims 1 to 8, preferably Claim 4, 5 or 8, characterised in that

— the cover (D) is formed by a sheet (D) onto one side of which the heating resistor (H) is printed, and, on the other side of which the theoretical interruption point (A) is arranged.

10. A board as claimed in one of Claims 1 to 9, characterised in that

— a thermally-sensitive sensor (SS), and/or the component (R) measured by the sensor is provided with a heat-conducting body (K).

11. A board as claimed in one of Claims 1 to 9, characterised in that

— a poor heat-conducting heat accummulating arrangement (L) is arranged on that side of the heating resistor (H) remote from the theoretical interruption point (A).

12. A board as claimed in Claim 11, characterised in that

— the heat accummulating arrangement (L) is formed by an aperture (L), which contains air, in the substrate beneath the heating resistor (H).

13. A board as claimed in one of Claims 1 to 12, characterised in that

— the theoretical interruption point (A) is inserted into a conductor path (B) of the current supply of the circuit.

14. A board as claimed in one of Claims 1 to 12, characterised in that

— the circuit forms a subscriber connection circuit of a telephone system ; and

— the theoretical interruption point (A) is inserted into a conductor path which forms a subscriber connection wire (a, b).

15. A board as claimed in one of preceding Claims, characterised in that

— the heating resistor (H) is provided with a thermal capacitance (WE, WK).

16. A board as claimed in Claim 15, characterised in that

— the thermal capacitance is formed by an appropriately-dimensioned heat-conducting body (WE, WK).


**Revendications**

1. Plaquette utilisée comme support de circuits comportant

— au moins une voie conductrice (B) en forme de couche, c'est-à-dire par exemple une voie conductrice à couche mince (B) et/ou une voie conductrice à couche épaisse (B) et/ou une voie conductrice gravée (B), sur un substrat (S) en forme de plaquette,

— une résistance de chauffage (H), réalisée par exemple sous la forme d'une couche, chauffée conformément à une charge en courant et pouvant être déposée par exemple sous la forme d'une résistance à couche épaisse (H) sur la surface (S) du substrat,

— un revêtement électriquement isolant (D), par exemple en forme de couche, réalisant une conduction au moins assez bonne de la chaleur et situé sur la résistance de chauffage (H), et

— un fusible électrique (A), qui est déposé sur le revêtement (D), qui est séparé de la résistance de chauffage (H) par ce revêtement (D), et qui répond à des températures excessives, est déposé de manière à établir un bon contact thermique et contient une zone de coupure de consigne (A) servant à interrompre la voie conductrice (B), dans laquelle la zone de coupure de consigne (A) est insérée dans la direction longitudinale, notamment pour des plaquettes de support de raccordement d'abonnés, caractérisée par le fait que

— la résistance de chauffage (H) est alimentée par un amplificateur (V), et

— l'amplificateur (V) est commandé par un capteur (SS) qui mesure une charge électrique, thermique, optique, acoustique et/ou mécanique à laquelle est soumise une voie conductrice (B) ou un composant (R) de la plaquette.

2. Plaquette suivant la revendication 1, caractérisée par le fait que

— le capteur (SS) et/ou l'amplificateur (V) possède une telle valeur de seuil de réponse que, même dans le cas d'un accroissement seulement lent du paramètre mesuré par le capteur (SS), la résistance de chauffage (H) est chauffée rapidement, uniquement au-dessus de la valeur de seuil de l'amplificateur (V), à une température suffisante pour réaliser rapidement l'interruption au niveau de la zone de coupure de consigne (A).

3. Plaquette suivant la revendication 1 ou 2, caractérisée par le fait que

— le fusible (A) forme dans son ensemble un composant compact discret (X).

4. Plaquette suivant la revendication 1,2 ou 3, caractérisée par le fait que

— la zone de coupure de consigne (A) forme un élément (A) en forme de couche conductrice dans l'étendue d'une voie conductrice (B).

5. Plaquette suivant la revendication 4, caractérisée par le fait que

— la section transversale conductrice est plus petite dans l'élément (A) que dans la voie conductrice considérée (B).

6. Plaquette suivant la revendication 4 ou 5, caractérisée par le fait que

— l'élément (A) est constitué en un matériau qui fond à une température plus faible que les autres éléments de la voie conductrice (B) considérée.

7. Plaquette suivant l'une des revendications 4,5 ou 6, caractérisée par le fait que

— l'élément (A) est recouvert par un capot de revêtement (P) collectant les projections lors de la coupure, et

— l'élément (A) est disposé dans l'espace entre le capot de revêtement (P) et le revêtement (D).

8. Plaquette suivant l'une des revendications 1 à 7, caractérisée par le fait que

— la résistance de chauffage (H) agit simultanément sur plusieurs emplacements de coupure de consigne (A), parmi lesquels un emplacement de coupure de consigne (A) particulier est dimensionné de telle sorte que, dans le cas d'une interruption, il interrompt complètement, en dernier, sa voie conductrice (B = BH), et

— la zone de coupure de consigne (A) particulière est branchée en série avec la résistance de chauffage (H) et interrompt par conséquent, dans le cas d'une coupure, le courant circulant dans la résistance de chauffage (H).

9. Plaquette suivant l'une des revendications 1 à 8, de préférence suivant la revendication 4,5 ou 8, caractérisée par le fait que

— le revêtement (D) est formé par une feuille (D), sur une face de laquelle la résistance de chauffage (H) est imprimée et sur l'autre face de laquelle la zone de coupure de consigne (A) est disposée.

10. Plaquette suivant l'une des revendications 1 à 9, caractérisée par le fait que

— un corps de conduction thermique (K) est monté à proximité d'un capteur (SS) sensible à la chaleur ou d'un composant (R) que ce capteur mesure.

11. Plaquette suivant l'une des revendications 1 à 9, caractérisée par le fait que

— un dispositif (L) d'accumulation de chaleur, est monté sur la face de la résistance de chauffage (H), tournée à l'opposé de la zone de coupure de consigne (A).

12. Plaquette suivant la revendication 11, caractérisée par le fait que

— le dispositif d'accumulation de chaleur (L) qui est formé par un trou (L) contenant de l'air est ménagé dans le substrat au-dessous de la résistance de chauffage (H).

13. Plaquette suivant l'une des revendications 1 à 12, caractérisée par le fait que

— la zone de coupure de consigne (A) est insérée dans une voie conductrice (S) de l'alimentation en courant du circuit.

14. Plaquette suivant l'une des revendications 1 à 12, caractérisée par le fait que

— le circuit forme un circuit de raccordement d'abonnés d'un système de téléphonie, et

— la zone de coupure de consigne (A) est insérée dans une voie conductrice constituant un conducteur (a, b) de raccordement de l'abonné.

15. Plaquette suivant l'une des revendications précédentes, caractérisée par le fait que

— une capacité calorifique (WE, WK) est prévue dans le cas de la résistance de chauffage (H).

16. Plaquette suivant la revendication 15, caractérisée par le fait que

— la capacité calorifique est formée par un corps de conduction thermique (WE, WK) dimensionné de façon correspondante.

# FIG 1

$R_i \leq 10\,\Omega$

$200\text{-}300\,V_{eff}$

$R_i \leq 10\,\Omega$

b

a

$r \approx 1\,\Omega$

$r \approx 1\,\Omega$

S

V

K

SS

BS

$30\,\Omega$

B

B

BH

+

H

BH

FF

Alarm

L

U

0 188 695

0 188 695

# FIG 2

# FIG 3

# FIG 4

# FIG 5

FIG 6

FIG 7

FIG 8

FIG 9

FIG 10

# FIG 11

# FIG 12